(19) **Europäisches Patentamt / European Patent Office / Office européen des brevets**

(11) **EP 1 745 516 B1**

(12) **EUROPEAN PATENT SPECIFICATION**

(45) Date of publication and mention
of the grant of the patent:
**23.11.2011 Bulletin 2011/47**

(21) Application number: **05742101.8**

(22) Date of filing: **16.05.2005**

(51) Int Cl.:
*H01L 29/772* (2006.01)    *H01L 51/30* (2006.01)
*B82B 1/00* (2006.01)    *B81B 3/00* (2006.01)

(86) International application number:
**PCT/SE2005/000691**

(87) International publication number:
**WO 2005/112126 (24.11.2005 Gazette 2005/47)**

(54) **ELECTROMECHANICAL NANOTUBE TUNNELING DEVICE COMPRISING SOURCE, DRAIN AND GATE**

ELEKTROMECHANISCHE NANORÖHREN-TUNNELEINRICHTUNG MIT SOURCE, DRAIN UND GATE

DISPOSITIF NANOTUBE ÉLECTROMÉCANIQUE À EFFET TUNNEL COMPRENANT UNE SOURCE, UN DRAIN ET UNE ÉLECTRODE DE GRILLE

(84) Designated Contracting States:
**AT BE BG CH CY CZ DE DK EE ES FI FR GB GR HU IE IS IT LI LT LU MC NL PL PT RO SE SI SK TR**

(30) Priority: **14.05.2004 US 570882 P**

(43) Date of publication of application:
**24.01.2007 Bulletin 2007/04**

(73) Proprietor: **Chalmers Intellectual Property Rights AB**
**412 88 Göteborg (SE)**

(72) Inventors:
• **VIEFERS, Susanne**
  **N-0553 OSLO (NO)**
• **NORD, Tomas**
  **NL-1011 MH AMSTERDAM (NL)**
• **KINARET, Jari**
  **S-413 61 MÖLNDAL (SE)**
• **JONSSON, Magnus**
  **S-421 35 VÄSTRA FRÖLUNDA (SE)**

• **AXELSSON, Sven**
  **S-612 46 FINSPÅNG (SE)**

(74) Representative: **Aurell, Henrik et al**
**Albihns.Zacco**
**Studentgatan 4**
**Box 4289**
**203 14 Malmö (SE)**

(56) References cited:
**WO-A-03/078305    US-A1- 2003 148 562**
**US-A1- 2003 157 744    US-A1- 2003 218 224**
**US-A1- 2003 230 760**

• **UNGERSBOCK E. ET AL: 'Simulation of Carrier Transport in Carbon Nanotube Field Effect Transistors' EUROPEAN SOLID-STATE DEVICE RESEARCH September 2003, pages 411 - 414, XP010676595**
• **KINARET J.M. ET AL.: "A carbon-nanotube-based nanorelay", APPLIED PHYSICS LETTERS, vol. 82, no. 8, 24 February 2003 (2003-02-24), pages 1287-1289,**

## Description

### Field of invention

The present invention relates to a nanotechnology component and more particular to a nanoelectromechanical component having means for influencing the flow of a small electrical current through the component.

### Technical background

Nanotechnology is an expanding research field in which development of nanoelectromechanical systems (NEMS) is included. NEMS is based on an electromechanical coupling in systems with length scales in the nanometer range. The small length scale of these systems allows for high intrinsic mechanical frequencies, and electromechanical resonances in the GHz-regime are possible. These resonances can be used to design high frequency electronic components on the nanometer scale.

The present invention is a further development of the system presented in patent WO 03078305: *A Nanotube Relay Device* and having three of the inventors in common, and on components incorporating either the original or the modified, and operating design at high frequencies. Prior art also includes DE 10034315 A1 and WO 0161753 A1 to Infineon Technologies AG.

### Summary of the invention

The present invention is a nanoelectromechanical device as defined in claim 1. The device comprises a nanotube, preferably a conducting nanotube, suitably a carbon nanotube.

The device further includes a non-conducting supporting structure, made of a non-conducting material such as for example silicon, Si, which supports at least a first portion of the nanotube, with another second portion of the nanotube protruding beyond the supporting structure, and thus being unsupported. The first, supported, portion of the nanotube is connected to an electrode, referred to from now on as the source electrode, by means of a source-tube connection having special properties.

The source-tube connection is a connection where a source-to-tube distance between the conducting source electrode and the conducting nanotube is in the range where quantum mechanics phenomena, in particular the so called tunnel effect, also called quantum leakage can occur.

The device according to the invention also provides means for controlling the magnitude of said tunnel effect. Said means preferably comprise two or more gate electrodes, see below.

Providing such a tunnelling contact at the source-tube junction has the advantages of:

- enabling the control of exact number of electrons in the nanotube;
- a system that can be so devised that every new added amount of charge, which is tunnelled into the nanotube, will correspond to a specific mechanical equilibrium position of the nanotube before the potential is levelled out. This results in a precise mechanism of transportation, usable as a kind of "stepper motor".

The supporting structure is suitably shaped as a terrace, and thus has a "step-like" structures, with an upper level, and a lower level, where the two levels are interconnected by a wall-like shape of the supporting structure. The difference in height between the two levels of the structure as defined by the height of the wall is referred to by the letter *h*. It should be noted that the use of the word "level" throughout this description refers to a difference in dimensions which gives the structure a preferably step-like form either in the horizontal or in the vertical orientation of the device.

On the lower level of the structure, there are arranged two or more additional electrodes, some of which being referred to as gate electrodes and others as the drain electrodes. The gate electrodes are located at a distance $L_G$ to the nearest point of the wall, and the corresponding distance for the drain electrodes are denoted as $L_D$, where $L_G$ suitably is smaller than $L_D$.

The total extension of the protruding part of the nanotube is preferably within the interval of 50 to 150 nm, suitably of the order of approximately 100 nm, with the height h being approximately in the order of size of 3 nm.

When a voltage is applied to the gate electrodes, a resulting capacitive force will act on the nanotube, in the direction towards the gate electrode, which is thus a direction defined by the lateral extension of the nanotube. When the mentioned force acts, the nanotube will deflect towards the gate electrodes, thereby reducing a tube-to-drain distance between the nanotube and the at least two drain electrodes. The amount of deflection is such that the distance between the tube tip and the drain electrodes can be varied from a distance with very high impedance, over a distance where tunnelling phenomena is dominant, to a distance of zero, where the tube tip directly abuts the drain electrode, and impedance is very low.

By applying voltages of different amplitudes and frequencies the device can be controlled to give different characteristica for a source-drain current flowing from the source electrode through the tube to the drain electrodes, as will be explained below.

### Brief description of the drawings

The invention will be described in detail below with reference to the accompanying drawings, in which:

Fig. 1 shows a schematic side view of a nanoelectromechanical component according to a preferred embodiment of the present invention.

Fig. 2 shows an equivalent circuit diagram of the component in fig. 1.

Fig. 3a-f shows schematically components having different configurations with several gate and drain electrodes.

Fig. 4a shows a stability diagram showing the positions of zero net forces on the tube of the component in fig. 1 for different gate voltages.

Fig. 4b shows the current as a function of gate voltage corresponding to the stability plot in fig. 4a.

Fig. 5a shows a stability diagram for a non-contact mode system.

Fig. 5b shows a diagram of the current as a function of source-gate voltage, corresponding to the stability plot in fig. 5a.

Fig. 5c shows a modification of the component in fig. 1.

Fig. 6 shows a diagram of resonance frequency for a non-contact mode system as a function of gate voltage.

Fig. 7 shows a diagram of the vibration peak to peak amplitude for a contact mode system as a function of modulation frequency.

Fig. 8a shows a diagram of maximum and minimum displacements of the tube in a contact mode system as a function of modulation frequency.

Fig. 8b shows a diagram similar to that in fig. 8a, when the tube switches state to a position close to the surface for some frequencies.

Fig. 9 shows a diagram of observed resonances for a non-contact mode system as a function of modulation frequency and gate voltage bias.

Fig 10a-b show diagrams of frequency responses in non-contact mode at operation.

Fig. 11 shows a component according to the invention as a box.

Fig. 12 shows a schematic illustration of a filter circuit embodiment of the invention.

Fig. 13 shows a schematic illustration of a detector application of an embodiment of the invention.

Fig. 14 shows a schematic illustration of a voltage controlled oscillator according to an embodiment of the invention.

Fig. 15 shows a schematic illustration of a variable capacitor circuit according to an embodiment of the invention.

Fig. 16 shows a nanoelectromechanical component provided with a cavity enabling greater oscillations of the nanotube.

## Detailed description of preferred embodiments

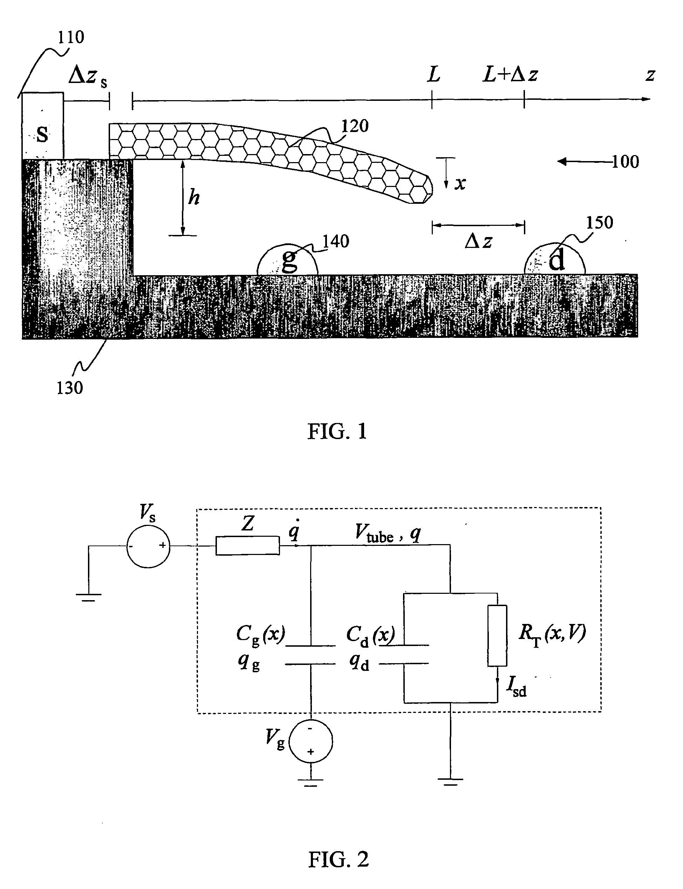

An illustration of the basic system is depicted in fig. 1 and the corresponding equivalent circuit is shown in fig. 2. A nanotube or a nanowhisker 120, preferably a conducting nanotube, suitably a carbon nanotube, of length $L$ is placed on a terraced non-conducting substrate 130 such that a tip end 160 is free to move and a base end 170 is firmly connected to the terraced non-conducting substrate 130 on the higher part of the terrace - the term *higher* refers to the figure and does imply a particular spatial orientation. The tube-source contact may be a tunnel junction, corresponding to $\Delta z_s > 0$, or a contact allowing continuous charge transfer if $\Delta z_s = 0$. The impedance of the tube-source contact is denoted by $Z$ and the electrostatic potentials on the source, gate and drain electrodes are denoted $V_s$, $V_g$, $V_d$, respectively. The potential on the tube is $V$. The direction along the tube axis is denoted $z$ and the tube tip 160 is located at $z=L$. Two additional electrodes (gate and drain) are positioned beneath the free end of the tube at $z_g < L$ and $z_d = L + \Delta z$ respectively. The ratio $z_g/L = z_r$ gives the relative position of the gate compared to the tube tip, and $\Delta z \gtrsim 0$ distinguishes between two modes of operation. The "contact mode" is defined by $\Delta z = 0$ whereas the "non-contact mode" occurs for $\Delta z \gg \lambda$, where $\lambda \approx 0,5$ Å is the tunnelling length.

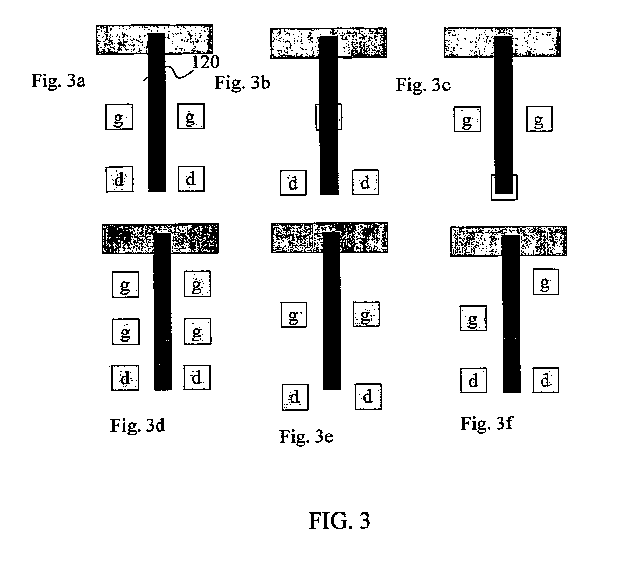

Fig. 3 shows from above how the structure may also comprise a multitude of gate and drain electrodes.

Fig. 3a shows an arrangement with two gate electrodes g and two drain electrodes d. The gate electrodes are arranged, one on each side of the nanotube 120 and below.

The drain electrodes d are arranged also one on each side and below of the nanotube 120, and closer to the tip of the tube than the gate electrodes g. This electrode placing enables a greater freedom in control of vibration modes of the nanotube 120.

Fig. 3b shows an alternative arrangement with one gate electrode g and two drain electrodes d. The gate electrode g is arranged directly under the nanotube 120, whilst the two drain electrodes d are arranged, one on each side of the nanotube opposite of each other. However, this arrangement does not form a part of the invention and is not covered by the claims.

Fig. 3c shows another alternative arrangement with two gate electrodes g and one drain electrode d. The gate electrodes are arranged, one on each side of the nanotube 120 and opposite of each other. However, this arrangement does not form a part of the invention and is not covered by the claims.

Fig. 3d shows an arrangement with four gate electrodes g, and two drain electrodes d. The gate electrodes g are arranged two on each side of the nanotube 120 in a quadratic or rectangular fashion in pairs. The drain electrodes d are arranged one on each side of the nano-tube opposite of each other.

Fig. 3e shows an arrangement with two gate electrodes g and two drain electrodes d, where the gate electrodes g are arranged as in fig. 3a and where the drain electrodes d are arranged beyond the nanotube 120, one on each side of the imaginary extension of said tube 120.

Fig. 3f shows an arrangement with two gate electrodes g and two drain electrodes d where the gate electrodes are arranged asymmetrically with reference to the nanotube 120.

The arrangement of fig. 3a and 3d-3f allows for greater and different freedom in control of vibration modes of the nanotube. These arrangements make it possible to superimpose movements orthogonally to the elongation of the tube 120 different from the deflection mentioned in connection with fig. 1.

The tube tip can be electrostatically bent towards the drain electrode by controlling the voltages on the electrodes, thereby inducing an excess charge $q$ on the tube. The deflection of the tube tip is measured vertically towards the substrate and is denoted $x$. In the contact mode, the tube mechanically contacts the drain electrode when $x = h$, where $h$ is the vertical distance from the straight tube to the contact. In the non-contact mode, the tube never reaches the electrode. The tube tip-drain contact is a tunnel junction, and decreasing the distance between the tube and the drain electrode reduces the tunnelling resistance $R_T(x, V)$, and allows a tunnelling current $I_{sd}$ to flow over the junction. The basic principle of operation is thus to mechanically reduce the barrier width by means of a capacitive coupling, which in turn leads to an electric current in the system.

In other words, fig. 1 shows how an end of a conducting nanotube or nanowhisker of length $L$ is free hanging over a terraced non-conducting substrate on which additional electrodes (gate and drain) are placed underneath the tube. The other end of the tube is electrically connected to a source electrode, the distance $\Delta z_s$ controls the tunnelling resistance of the source junction. An ohmic contact is possible if $\Delta z_s = 0$. The vertical distance between a straight tube and the gate and drain electrodes is $h$ and the horizontal distance between the tube tip and the electrode is $\Delta z$. The tube tip can be deflected a distance $x$ in the vertical direction by means of the voltages on the electrodes. A large enough deflection reduces the tunnelling resistance enough to allow for a tunnelling current from the tube tip to the drain electrode. Fig. 2 shows the corresponding equivalent circuit of the system. The parts within the dashed line are the equivalent circuit of the component of fig. 1, whereas the parts outside said dashed line are external parts. This "box notation" will be used later. The tube-source junction is has impedance $Z$ over which a charge $q$ flows, the tube-gate coupling is purely capacitive with capacitance $C_g(x)$ and the tube is connected to the drain by a tunnel junction with tunnelling resistance $R_T(x, V)$ and capacitance $C_g(x)$. A stochastic tunnelling current $I_{sd}(x, V)$ flows between the tube and the drain electrode

## General considerations

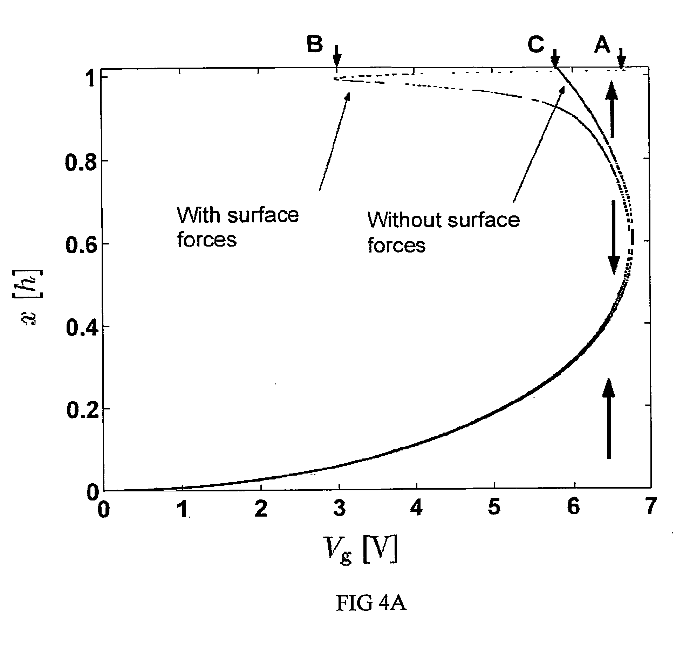

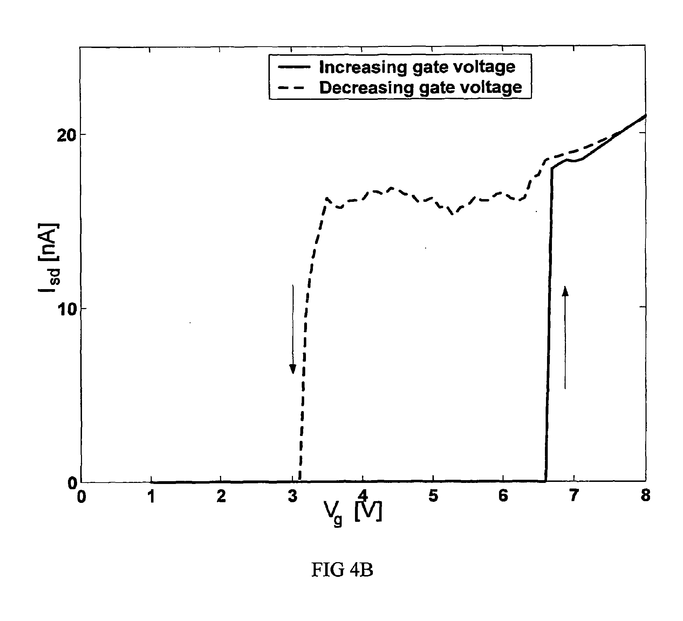

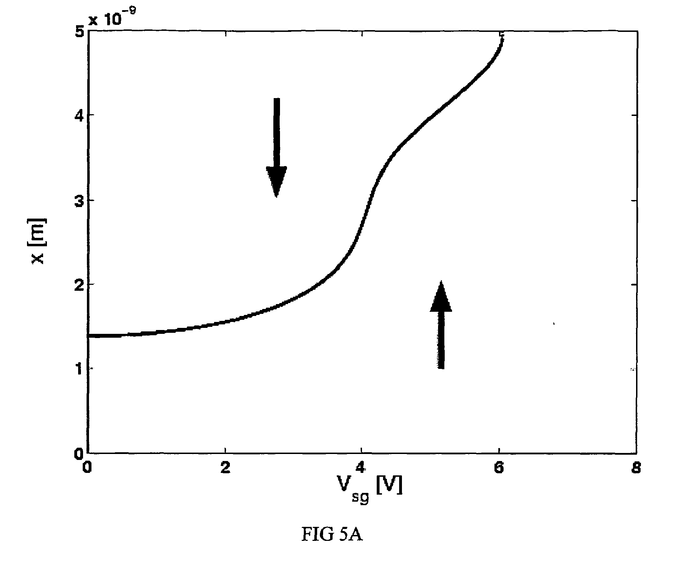

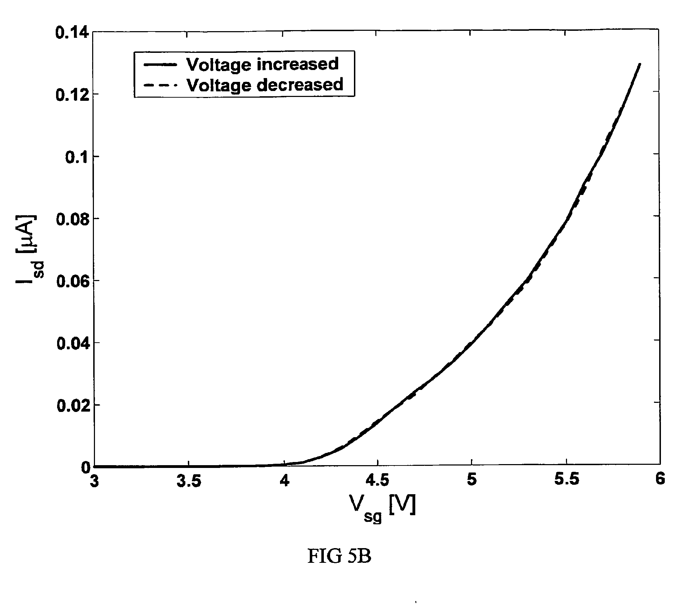

There is a strong coupling between the electrical and mechanical degrees of freedom in the system. The geometry of the system depends on the electrostatic potentials on the electrodes, and the electrical properties depend in turn of the geometry of the system. For a typical contact mode system, the equilibrium tube position as a function of gate voltage can be deduced from fig. 4a and the corresponding current voltage characteristics is depicted in fig. 4b. For the non-contact mode system the corresponding plots are depicted in fig. 5a and 5b.

## Multiple nanotubes

In one embodiment several nanorelays are arranged parallelly to each other to increase the possible current through such a structure.

## Materials and structures

In alternative embodiments the tube 120 is a carbon nanotube, a silicon carbide nanotube, a nanowire or a nanowhisker.

Fig. 4a shows a stability diagram with and without short range surface forces for a typical contact mode system. The curve shows the positions of zero net force on the tube (or local equilibria) as functions of gate voltage (at constant $V_s = 0{,}01$ V) and deflection $x$ (in units of $h$). The large arrows show the direction of the force on each side of the curves, indicating one local equilibrium to be unstable in the region where three equilibria exist. The required voltage for pulling the tube to the surface (pull-in voltage) is given by A ($\approx 6{,}73$V). This voltage is not significantly affected by surface forces. A tube at the surface will not leave the surface until the voltage is lower than the release voltage, B and C in the figure. Note that A > B, C, which indicates a hysteretic behaviour in the $IV_g$-characteristics, a feature significantly enhanced by surface forces. Fig. 4b shows the current voltage characteristics corresponding to the stability plot in fig. 4a with surface forces.

Fig. 5a shows a stability diagram for the non-contact mode system. The arrows show the direction of the force on the tube tip in the two regions. Only one equilibrium position for each voltage is seen for this set of design parameters, and the system characteristics have no hysteresis. Fig. 5b shows source-drain current versus source-gate voltage characteristics corresponding to the stability plot in fig. 5a.

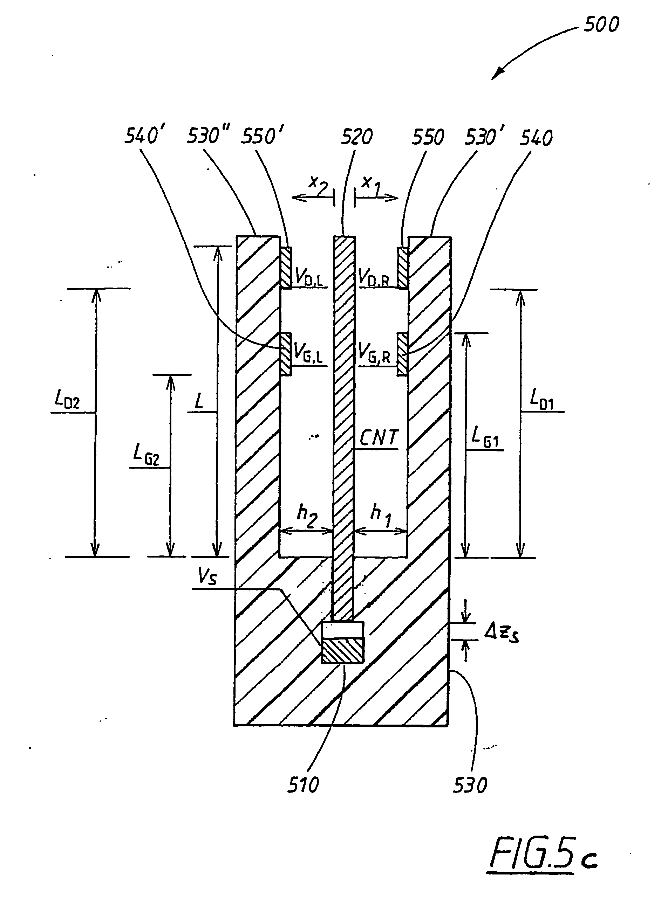

Fig. 5c shows a top view of another embodiment 500 of the invention. This embodiment 500 comprises a nanotube device similar to that shown in fig. 1 and described above, but with the supporting, terraced structure 530 additionally comprising a structure 530" on a third level, said third level 530" being located essentially in parallel with the second level 530', but on a an opposite side of the protruding part of the nanotube 520.

The embodiment 500 also comprises tunnelling source-tube junction due to the distance $\Delta z_s$ between a source 510 and a nanotube 520.

The embodiment 500 comprises essentially all of the feature of the device in fig. 1, and additionally comprises second means 540' for exerting a force upon the nanotube 520 in a second direction defined by its lateral extension, so that when said force exceeds a certain level, the second part of the nanotube will flex in the second direction of its lateral extension, and thereby close or making a tunnel junction in a second electrical circuit. Said second direction is, as will be realized from fig. 5, the direction which is towards the means 540', which are preferably a second gate electrode, the second, protruding part of the nanotube 520 will flex in the second direction of its lateral extension, and thereby close a second electrical circuit. This second electrical circuit is suitably defined by the source electrode 510 described in connection with fig. 1, and a second drain electrode 550' located on the third level 530'' of the supporting structure 530.

The second gate and drain electrodes are located at distances $L_{G2}$ and $L_{D2}$, respectively, from the wall of the terraced structure.

Short range forces

Short range surface forces (forces with a stronger distance dependence than the Coulomb interaction) influence the operational characteristics if the tube at any time gets closer than a few nanometers from mechanical contact with any part of the structure not including the source electrode. The primary net effect of these forces is to increase hysteresis. This makes a memory element a particularly interesting application particularly for the contact mode structure. Such a memory element can be designed to be either volatile or non-volatile using, for example, the three-terminal contact mode system or the five terminal structure of patent WO 03078305. In this respect "volatile" refers to an embodiment, where the nanotube is designed to have a mechanical stiffness, such that the mechanical forces due to said stiffness are enough to loosen the nanotube from the drain electrode when $V_g$ becomes close to zero. The stiffness can be achieved by e.g. a short nanotube or a nanotube with large diameter. "Non-volatile" refers to an embodiment, where it is necessary to provide a current pulse, heating the electrode to loosen said nanotube from the drain electrode. Such a current pulse can be provided by a pulse-generating device connected to the source.

High frequency properties

The high intrinsic mechanical frequency of the device can be used to design components based on a nanoelectromechanical resonances with resonance frequencies reaching the GHz regime.

*Electromechanical resonances*

Contact mode

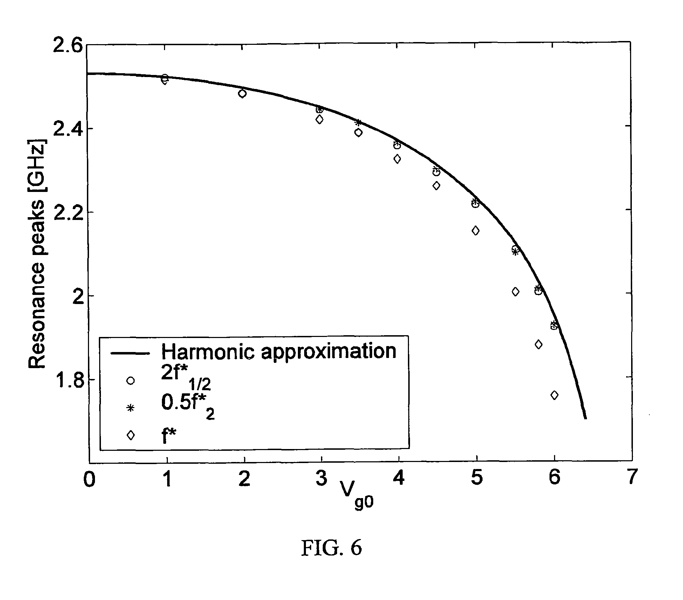

The equilibrium positions of the tube, which can be deduced from fig. 4a and 5a, are determined by the local minima of the total tube potential. The mechanical resonance frequency is determined by the curvature of the total potential near the potential minima (harmonic approximation). Since the total potential can be controlled by the external voltages, both the tube equilibrium position and the mechanical resonance frequency are controllable by electrostatic means. Hence, the resonance frequency is a function of gate voltage as plotted in fig. 6 for a contact mode device. The lowest mechanical resonance frequency, denoted by $f^*$, can be varied over several GHz by tuning the gate voltage bias. Non-linear effects are important when considering the resonances. These non-linear effects change the location of the main resonance peak and make resonances at half and twice the resonance frequency possible. These resonances are denoted by $f^*_{1/2}$ and $f^*_2$ respectively.

In other words, fig. 6 shows the lowest resonance frequency of a typical contact mode system as a function of gate voltage. The values are compared to a prediction based on a harmonic approximation to the potential profile.

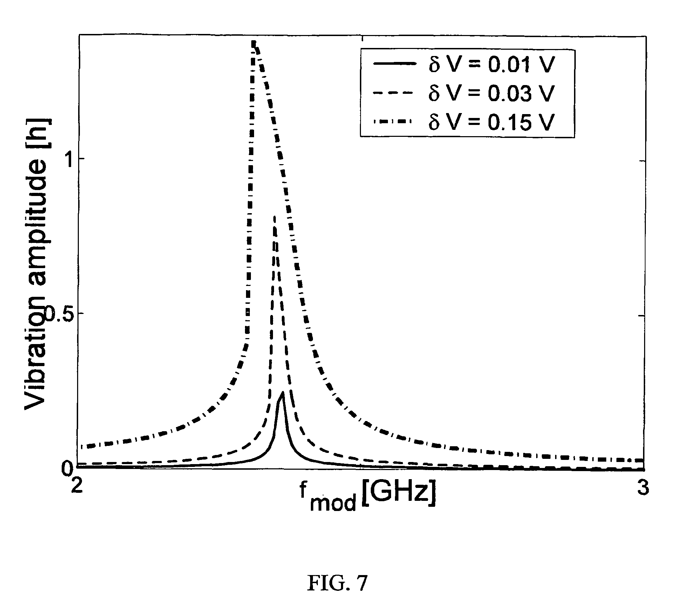

Fig. 7 shows the vibration amplitude (peak to peak) for the contact mode system as a function of modulation frequency for different values of the modulation amplitude $\delta V$. If the amplitude is small , the line shape is symmetric, whereas for larger amplitudes the shape is asymmetric and the peak position is shifted.

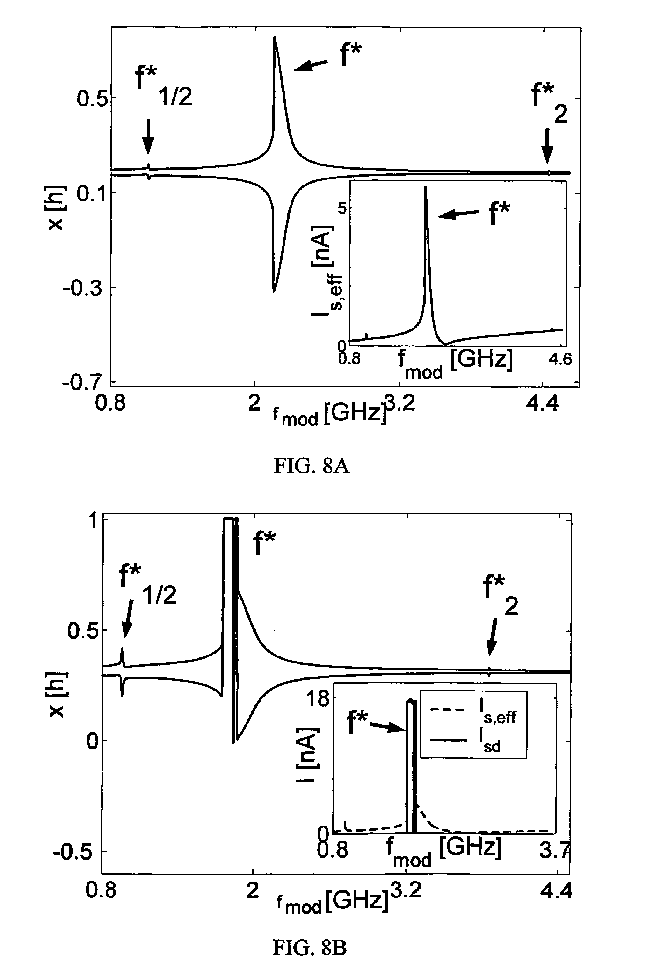

When a high frequency modulation is applied to the gate electrode of a contact mode structure, it may result in two qualitatively different outcomes. In the first case, the system's trajectory in phase space approaches a limit cycle, in which the tube never mechanically contacts the surface, but oscillates with a substantial amplitude. Due to the very high tunnelling resistance for large tube-drain separations, tunnel current through the system is negligible. However, since the geometry of the structure changes in time, so do the geometric capacitances, and also the charge on the tube changes in time with the same frequency. This results in a AC displacement current at the source and drain contacts with a frequency corresponding to the mechanical oscillation frequency. The frequency response of the system in this case is shown in fig. 8a and the effective value of the displacement current $i_{s,eff}$, determined assuming sinusoidal charge transfer as $i_{s,eff} = \max(\partial_t / \sqrt{2})$, is depicted in the inset. As can be seen, the resonance is accompanied by a large change in the displacement current. In the second case, if the oscillation amplitude is large enough, the system may impinge on the drain contact for a range of frequencies. Interactions between the tube and the drain electrode cause the tube lose some of its energy and help the tube to get trapped to a stationary state near the surface. The potential minimum near the surface corresponds to a high frequency compared to the minima far from the surface, implying that the gate modulation frequency is no longer at resonance, and energy transfer to a tube at the contact position is inefficient. The device has changed its state as a result of the modulation and a tunnelling current is feasible. The tube will continue to reside at the surface even after the gate modulation is removed. Thus, the system has a built-in memory, which remembers if a modulation within a certain frequency range has been applied. The frequency scan in this case is shown in fig. 8b, where, for a narrow interval near a resonance frequency, the tube ends up near the contact. Only in this narrow region do we get a non-zero tunnelling current. In both cases there are clearly visible resonances at half and the double frequency and, also, the line shape of the main resonance is asymmetric. Both these characteristics are due to deviations from the quadratic potential shape.

In other words, fig. 8 shows the maximum and minimum displacements in a contact mode structure in steady state for gate voltage biases (a) $V_{g0}$=5 V and (b) $V_{g0}$=6 V with gate voltage modulation $\delta V$=0,1 V with frequency $f_{mod}$. The largest peak corresponds to the resonance frequency, and the smaller to half and double frequency peaks. Inset in fig. 8a shows the amplitude of the source junction displacement current as a function of frequency. In fig. 8b is shown how the tube switches state to a position close to the surface for some frequencies, allowing a non-zero tunnelling current from the tube to the drain, i.e. "switches state" implies that the tube hits the substrate and sticks for certain frequencies because the amplitude of the oscillation is frequency dependent. Inset in fig. 8b depicts both effective displacement current $I_{s,eff}$, and the drain tunnelling current $I_{sd}$.

*Non-contact mode*

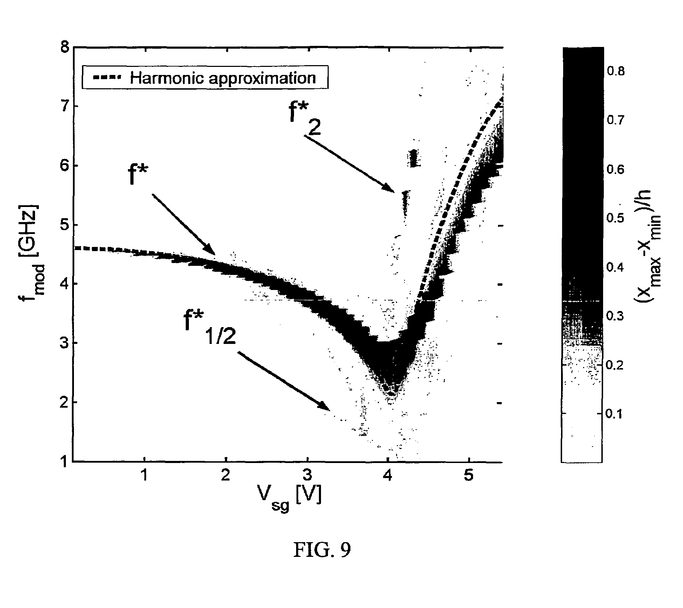

As for the contact mode we can predict resonance frequencies for a specific gate voltage using a harmonic approximation to the potential. This prediction is the dashed line in fig. 9. The prediction is compared to the observed oscillation amplitudes as a function of both gate voltage and modulation frequency. The dark areas correspond to resonances. The observed resonances follow approximately the qualitative behaviour of the harmonic approximation and the frequency for the main resonance can be changed even more than was possible in the non-contact mode system. Also note the $f^*_{1/2}$ and $f^*_2$ branches that are visible even in this case.

In other words, fig. 9 shows observed resonances in the non-contact mode of operation of the system as a function of modulation frequency and gate voltage bias. The harmonic approximation (dashed line) agrees well with the observed resonances in the low bias region and deviates from the predicted value for larger voltages. Note the clearly visible $f^*_{1/2}$ and $f^*_2$-branches.

The current through the system in the non-contact mode is significantly different from the current in the contact mode system. The large source-drain voltage allows for a current without mechanical contact and a non-zero tunnelling current is expected for all frequencies.

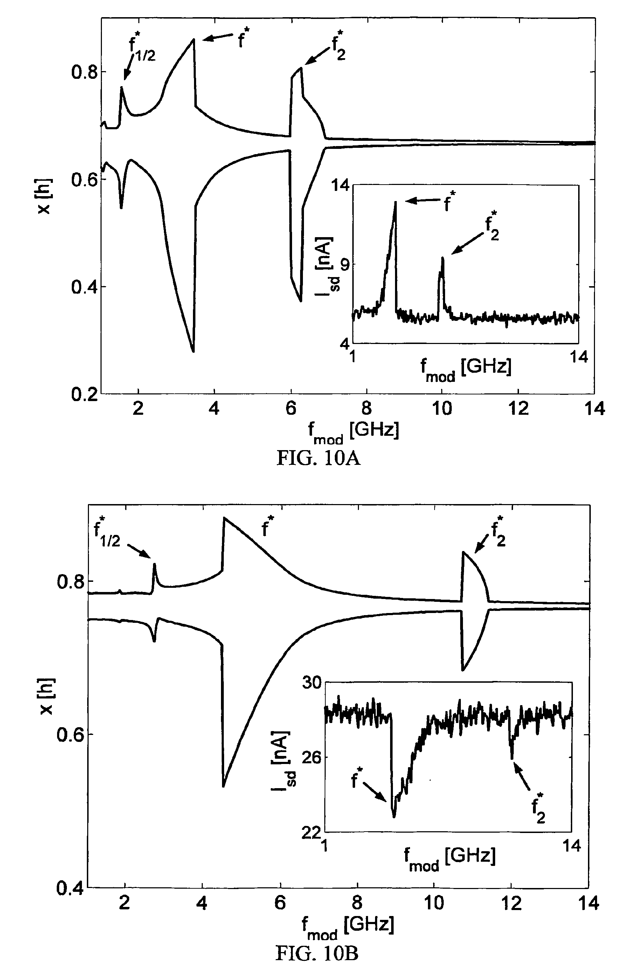

The current changes at resonance due to the tube oscillations, and may either increase or decrease depending on bias voltages - if the non-oscillatory position resulted in a large current, oscillations tend to reduce it, and vice versa. These two different cases are depicted in fig. 10, which shows the minimum and maximum tube deflection in the limit cycle, and the insets show the corresponding tunnelling currents. The most important conclusion from these figures is that the resonance changes the current, which implies that the resonance is detectable electrically. The line shape of the resonances is highly asymmetric, implying that the current changes abruptly on one side of the resonant frequency.

In other words, fig. 10 shows the frequency response in the non-contact mode of operation. Biasing points are (a) $V_{g0}$=4,3 V and (b) $V_{g0}$=4,8 V, amplitude of AC modulation is $\delta V$=0,1 V. The main resonance peak is highly asymmetric and both double-frequency and a half-frequency peaks are visible. Insets show the average tunnelling current as a function of frequency. The average current increases at the resonance in fig. 10a and decreases in fig. 10b. The sign and magnitude of the current change depend on the shape of the potential.

Dimensions

Dimensions vary with application and expectation of dynamics. In theory typical lengths are 80-100 nanometer, the terrace height h typically 8 nanometer, and the diameter typically 8 nanometer.

Examples of applications

Below are examples of components that can be designed using the system described earlier.

*Box notation*

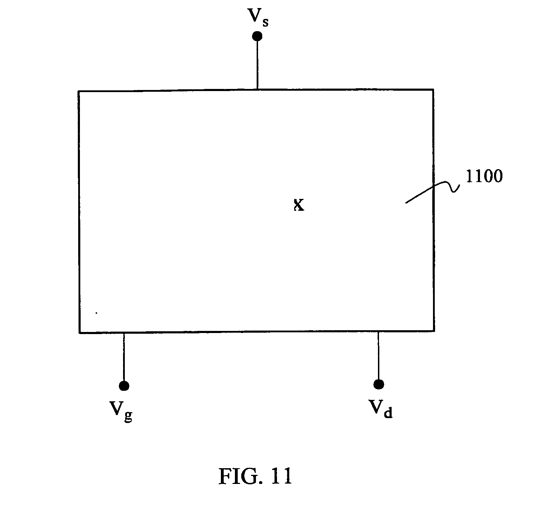

For simplicity, the examples are described using a box notation. The box contains a nanomechanical relay device, either in the contact or non-contact mode, and is connected to an external circuit through source, gate, and drain contacts, see fig. 11. Thus, we consider the system as a box which is connected to external circuits through three or five electrodes. If the relay utilizes the other configuration, e.g. the five-terminal configuration discussed in the patent WO 03078305) there are several gate and drain contacts.

*Memory element*

A memory element application is a potential application for the relay. Due to inelastic collisions between the tube and drain electrode in the contact mode system very fast writing times are attainable. The memory cell may be both volatile, requiring external voltage sources to store its value, or non-volatile, capable of maintaining its state even in the absence of external voltages. In the memory application, the box should contain a relay in the contact mode, with sufficient hysteresis as depicted in fig. 4b. The conducting state, in which the tube end is in close proximity to the drain electrode, is a logical "I", while the non-conducting state is a logical "0". The memory cell is volatile, if the lower edge of the hysteresis loop, denoted by B in fig. 4b, is positive. If the hysteresis loop extends to zero gate voltage, the memory element maintains its state even without external voltages, and is non-volatile. A non-volatile memory element can be reset to a non-conducting state by applying a large voltage pulse $V_{sd}$, thereby heating up the tube-drain contact. The resulting vigorous electron movements will discharge the tube from the drain electrode.

*Filter*

Exploiting the electromechanical resonance the system can be used as a filter by applying the input AS signal to the gate and reading of the output signal at the drain. Modulating the gate voltage with a signal with several frequency components suppresses frequency components with frequencies out of resonance. Since the resonance frequency is tuneable using the gate voltage bias $V_{g0}$, the system acts as a tuneable filter. The nanoelectromechanical element in this case can be either in the contact or non-contact mode, and the frequency range of the filter can be read off fig. 6 and 9.

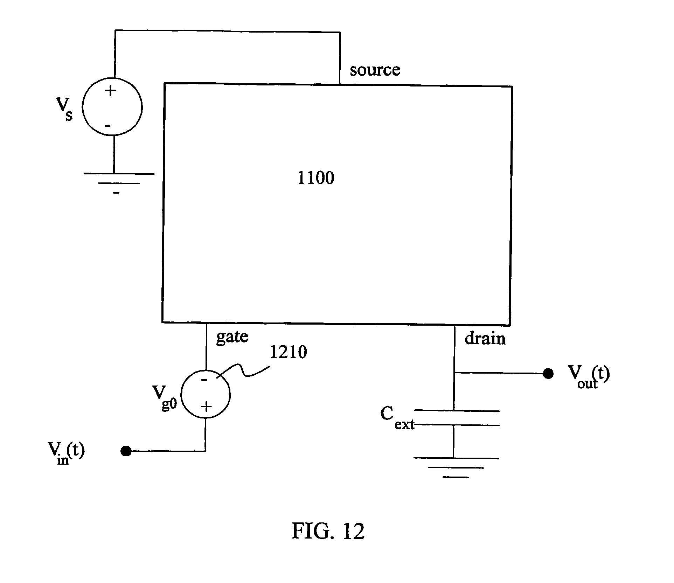

Fig. 12 shows schematically a filter application of the relay. The internal capacitances are functions of time which yields an output voltage which also varies in time with the frequency with which the tube oscillates. A gate voltage modulator 1210 is connected between the voltage input $V_{in}$ and the gate, to add an AC voltage.

*Variable bandwidth detector*

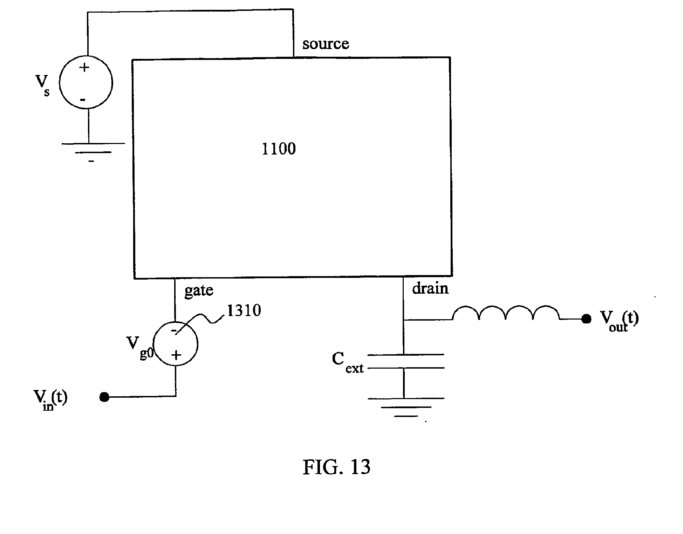

The system can be used as detector (fig. 13) which detects signals that are sufficiently close to the resonance frequency. The gate of the device 1600 is connected to a gate voltage modulator 1310. A gate voltage modulation with an appropriate frequency induces a response. The specific features of the response depend on the mode of operation. For the contact mode system, the tube changes its logical state which results in a change in the tunneling resistance, and consequently a DC current at the drain, as shown in fig. 8b. When the gate modulation is turned off, the tube remains at the surface (unless the gate bias is removed, or even in the absence of gate bias if the design parameters correspond to those of a non-volatile memory element) and the detector has a memory. The bandwidth of the detector is a function of both gate bias and signal amplitude and can be tuned. The resonance frequency is, as mentioned earlier, a function of gate bias. Thus, both the detector bandwidth and response frequency can be tuned. If the nanoelectromechanical component is in the non-contact mode, the current response at drain may have either sign (cf. Figure 10), and the detector has no built-in memory.
Fig. 13 shows schematically a detector application. If a signal with an appropriate frequency is applied to the gate, the system changes its logical state which results in a source (drain) current. The system can be designed with a built-in memory so that the system remembers if a signal has been applied.

*Oscillator*

The capacitance between the tube and the drain electrode is a function of time. Inserting a capacitance between the drain electrode and ground gives a time-dependent voltage, $V_{out}(t)$. With a feedback circuit 1420 connected between the drain and a gate voltage modulator 1410, this time-dependent voltage can be superimposed on the gate voltage bias, which gives a modulation voltage with a frequency corresponding to the vibration frequency of the tube.

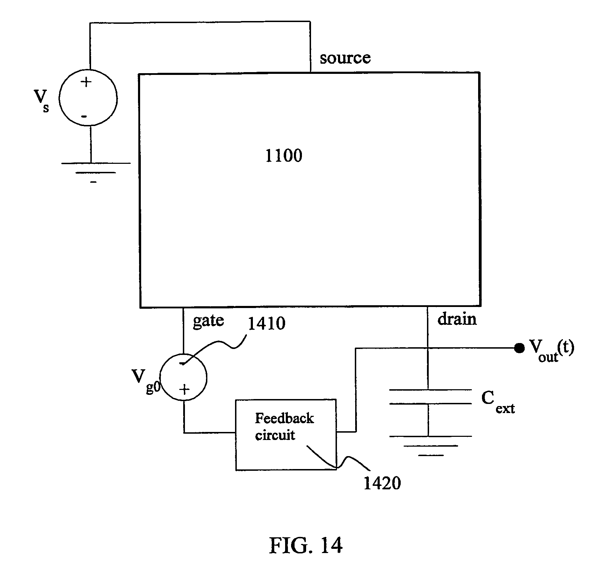

This structure is illustrated in fig. 14. With the feedback the tube therefore starts to oscillate in resonance. The oscillation may be started by applying a step pulse to the gate electrode. The oscillation frequency is tunable by the gate bias. The nanoelectromechanical component in this example can be either in the contact or non-contact mode.

In other words, fig. 14 shows how an output signal, which has a frequency determined by the resonance frequency, can be fed back via the feedback circuit 1420 to modulate the gate signal. With an appropriate phase shift this signal drives the oscillations.

*Variable capacitor*

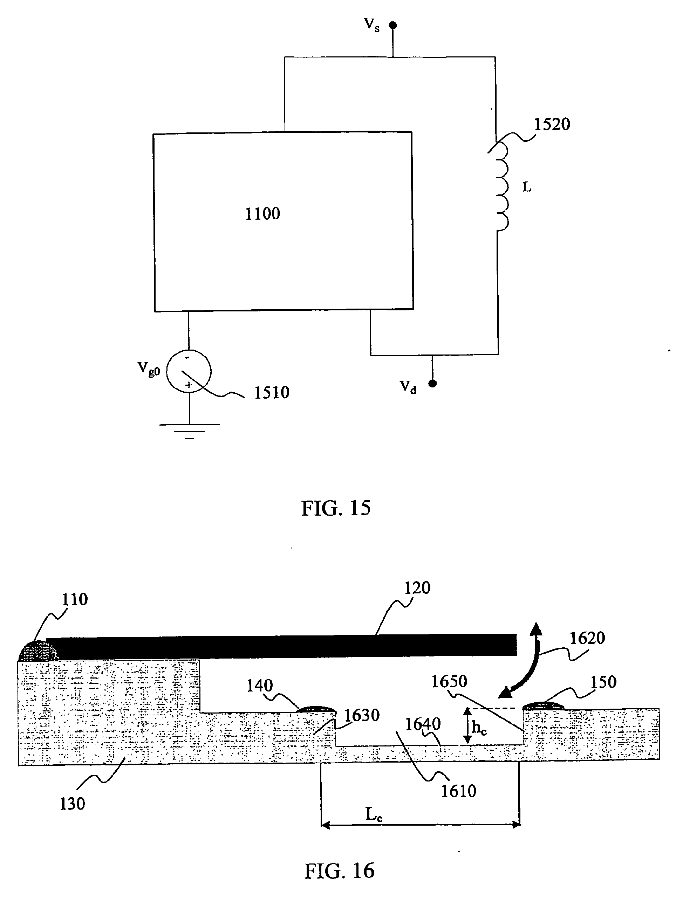

The capacitance between the tube and the drain is a function of gate voltage. Thus, the system can act as a tunable capacitor which in turn can be used in an electrical resonance circuit, see fig. 15. An inductive component 1520 with inductance L is connected between the source and the drain. The mechanical oscillation of the tube can be minimized by using a small $V_{sd}$, or by actively damping tube oscillations using a feedback to the gate with an appropriate phase shift (not depicted in the figure).

In other words, fig. 15 shows a variable capacitor, where the tube-drain capacitance depends on the gate voltage. The system is a variable capacitor that can be used to change the resonance frequency of an electric resonance circuit.

*Pulse generator*

The contact mode system can be used as a pulse generator by applying an AC signal to the gate, with a suitable amplitude and frequency such that, during one cycle, the tube tip contacts the drain electrode for part of the cycle.

*Electromechanical mixer*

By allowing higher mechanical modes of the tube motion, and by applying an AC signal with a suitable frequency to an appropriately placed gate electrode, the system will exhibit coupled mechanical motion, and may be used as a mechanical frequency mixer.

*Additional devices*

Additional applications may be constructed by connecting a multitude of individual devices to each other.

Cavity

Fig. 16 shows another embodiment of a nanoelectromechanical component according to the present invention. The substrate 130 is provided with a cavity 1610 under the nanotube provided with defining surfaces 1630, 1640 and 1650. The cavity is preferably having a depth $h_c$ and a length $L_c$ and a width (not shown) sufficient to house the tube 120, when the tube oscillates with large amplitude as indicated by arrow 1620, thereby enabling greater movement of said nanotube, without the tube 120 making contact with the substrate 130. In this embodiment the drain electrode 150 is arranged beyond the tube 120.

**Claims**

1. A nanotube device (100), comprising a nanotube (120) with a base end and a tip end and with a longitudinal and a lateral extension, a supporting structure (130) for supporting at least a first part of the nanotube (120) comprising the base end, and a first means comprising two gate electrodes (140, g) for exerting a capacitive force upon the nanotube in a first direction defined by its lateral extension, wherein at least a second part of the nanotube (120) comprising the tip end protrudes beyond the support of said structure (130), so that when said force exceeds a certain level, the second part of the nanotube will flex, and thereby reducing a tube-to-drain distance between the tube (120) and a drain electrode (150), **characterized in that** a source electrode (110) is arranged having a distance ($\Delta z_s>0$) to the base end of the nanotube (120) such that tunnelling can be made to occur between the nanotube (120) and said source electrode (110), and wherein said device further comprises two drain electrodes (150, d), and wherein the gate electrodes are arranged, one on each side of the nanotube (120), and below, and wherein the drain electrodes (150, d) are arranged, one on each side and below, relatively to the nanotube (120) and closer to the tip of the tube than the gate electrode.

2. A nanotube device according to claim 1, **characterized in that** the dimensions of said nanotube (120) and a size of a vertical distance (h) between the tube (120) and the supporting structure (130), and a size of a horizontal distance ($\Delta z>0$) between a tube (160) and the drain electrode (150) is such that tunneling can be made to occur between the tube (120) and said drain electrode (150).

3. A nanotube device according to claims 1 or 2, in which said supporting structure comprises a terraced structure with structures on a first and a second level, with the supported first part of the nanotube being supported by the first level of the structure, and said means for exerting force being located on said second level.

4. A nanotube device according to any of claims 1-3, in which a first circuit which impedance is affected by the flexing of the nanotube comprises a first gate electrode being located on said second level of the structure and a first source electrode being located on said first level of the structure.

5. A nanotube device according to any of the previous claims, in which the supporting terraced structure additionally comprises a structure on a third level, said third level being located essentially in parallel with said second level, but on an opposite side of the protruding part of the nanotube, which nanotube device comprises second means for exerting a force upon the nanotube in a second direction defined by its lateral extension, so that when said force exceeds a certain level, the second part of the nanotube will flex in the second direction of its lateral extension, and thereby affect the impedance of a second electrical circuit.

6. A nanotube device according to claim 5, **characterized in that** the second means for exerting said force upon the nanotube is an electrical means, the force being created by applying a voltage to the means.

7. A nanotube device according to claims 5 or 6, in which said additional supporting structure comprises a terraced structure with structures on a first and a second level, with the supported first part of the nanotube being supported by the first level of the structure, and said means for exerting force being located on said second level.

8. A nanotube device according to any of claims 5-7, in which the second means for applying force comprises a second gate electrode, and the second circuit which impedance is affected by the flexing of the nanotube comprises a second drain electrode being located on said third level of the structure.

9. A nanotube device (100) according to claim 1, where said device comprises four gate electrodes (g), and two drain electrodes (d), the gate electrodes (g) are arranged two on each side of the nanotube (120) in a quadratic or rectangular fashion in pairs and the drain electrodes (d) are arranged one on each side of the nanotube opposite of each other.

10. A nanotube device (100) according to claim 1, where said device comprises two gate electrodes (g) and two drain electrodes (d) where the drain electrodes (d) are arranged one on each side of the nanotube (120) and below and closer to the tip of the tube than the gate electrodes (g) and where the drain electrodes (d) are arranged beyond the nanotube (120), one on each side of the imaginary extension of said tube (120).

11. A nanotube device (100) according to claim 1, where said device comprises two gate electrodes (g) and two drain electrodes (d) where the gate electrodes are arranged asymmetrically with reference to the nanotube (120).

12. A memory element, **characterized in that** it comprises the device of claim 1.

13. A filter, **characterized in that** it comprises the device of claim 1, where said device comprises means for applying an input AC signal to the gate of the device, and means for reading the output signal at the drain.

14. The filter of claim 13, where said filter comprise means for applying a gate voltage bias for tuning a resonance frequency of said filter.

15. A variable bandwidth detector, **characterized in that** it comprises the device of claim 1, where the gate of the device is connected to a gate voltage modulator (1310).

16. An oscillator, **characterized in that** it comprises the device of claim 1.

17. The oscillator of claim 16, where a feedback circuit (1420) is connected between the drain and a gate voltage modulator (1410).

18. A variable capacitor, **characterized in that** it comprises the device of claim 1.

19. The capacitor of claim 18, where an inductive component (1520) is connected between the source and the drain.

20. A device according to any of the previous claims, where said tube (120) is made of carbon, silicon carbide or metal and/or is a nanowire or a nanowhisker.

21. A nanotube device according to claim 1, where said device is provided with a cavity (1610) in the substrate under the nanotube (120) enabling greater movement of said nanotube (120).

**Patentansprüche**

1. Nanoröhreneinrichtung (100), die eine Nanoröhre (120) mit einem Basisende und einem vorderen Ende und mit einer Erstreckung in Längsrichtung und einer seitlichen Erstreckung, eine Trägerstruktur (130) zum Unterstützen wenigstens eines ersten Teils der Nanoröhre (120), der das Basisende umfasst, und ein erstes Mittel aufweist, das zwei Gate-Elektroden (140, g) zum Ausüben einer kapazitiven Kraft auf die Nanoröhre in einer ersten Richtung, die durch deren seitliche Erstrekkung definiert ist, aufweist, wobei wenigstens ein zweiter Teil der Nanoröhre (120), der das vordere Ende aufweist, über den Träger der Struktur (130) hervorsteht, sodass, wenn die Kraft ein bestimmtes Niveau übersteigt, der zweite Teil der Nanoröhre sich biegen wird und sich dadurch ein Röhren-zu-Drain-Abstand zwischen der Röhre (120) und einer Drain-Elektrode (150) verringert,
**dadurch gekennzeichnet, dass**
eine Source-Elektrode (110) vorgesehen ist, die einen solchen Abstand ($\Delta zs > 0$) zum Basisende der Nanoröhre (120) aufweist, dass ein Tunneleffekt zwischen der Nanoröhre (120) und der Source-Elektrode (110) auftreten kann, und wobei die Einrichtung ferner zwei Drain-Elektroden (150, d) aufweist, und wobei die Gate-Elektroden jeweils eine auf jeder Seite der Nanoröhre (120) und unterhalb vorgesehen sind, und wobei die Drain-Elektroden (150, d) eine auf jeder Seite und unterhalb, relativ zur Nanoröhre (120) und näher am vorderen Ende der Röhre als die Gate-Elektrode angeordnet sind.

2. Nanoröhreneinrichtung nach Anspruch 1, **dadurch gekennzeichnet, dass** die Dimension der Nanoröhre (120) und eine Abmessung eines vertikalen Abstands (h) zwischen der Röhre (120) und der Trägerstruktur (130) und eine Abmessung eines horizontalen Abstands ($\Delta z > 0$) zwischen einer Röhre (160) und der Drain-Elektrode (150) so ist, dass ein Tunneleffekt zwischen der Röhre (120) und der Drain-Elektrode (150) auftreten kann.

3. Nanoröhreneinrichtung nach Anspruch 1 oder 2, bei der die Trägerstruktur eine gestufte Struktur mit Strukturen auf einem ersten und einem zweiten Niveau aufweist, wobei der unterstützte erste Teil der Nanoröhre von dem ersten Niveau unterstützt wird und das Mittel zum Ausüben einer Kraft auf dem zweiten Niveau positioniert ist.

4. Nanoröhreneinrichtung nach einem der Ansprüche 1 bis 3, bei der ein erster Schaltkreis, dessen Impedanz durch die Biegung der Nanoröhre beeinflusst wird, eine erste Gate-Elektrode, die auf dem zweiten Niveau der Struktur positioniert ist, und eine erste Source-Elektrode aufweist, die auf dem ersten Niveau der Struktur positioniert ist.

5. Nanoröhreneinrichtung nach einem der vorhergehenden Ansprüche, bei der die gestufte Trägerstruktur zusätzlich eine Struktur auf einem dritten Niveau aufweist, wobei das dritte Niveau im Wesentlichen parallel zum zweiten Niveau vorgesehen ist, aber auf einer gegenüberliegenden Seite des vorstehenden Teils der Nanoröhre, wobei die Nanoröhreneinrichtung ein zweites Mittel zum Ausüben einer Kraft auf die Nanoröhre in einer zweiten Richtung aufweist, die durch deren seitliche Erstreckung definiert ist, sodass, wenn die Kraft ein bestimmtes Niveau übersteigt, der zweite Teil der Nanoröhre sich in der zweiten Richtung deren seitlicher Erstreckung biegen wird, und dadurch die Impedanz eines zweiten elektrischen Schaltkreises beeinflusst wird.

6. Nanoröhreneinrichtung nach Anspruch 5, **dadurch gekennzeichnet, dass** das zweite Mittel zum Ausüben der Kraft auf die Nanoröhre ein elektrisches Mittel ist, wobei die Kraft durch Aufbringen einer Spannung auf das Mittel erzeugt wird.

7. Nanoröhreneinrichtung nach Anspruch 5 oder 6, bei der die zusätzliche Trägerstruktur eine gestufte Struktur mit Strukturen auf einem ersten und einem zweiten Niveau aufweist, wobei der unterstützte erste Teil der Nanoröhre von dem ersten Niveau der Struktur unterstützt wird und das Mittel zum Ausüben einer Kraft auf dem zweiten Niveau positioniert ist.

8. Nanoröhreneinrichtung nach einem der vorhergehenden Ansprüche 5 bis 7, bei der das zweite Mittel zum Aufbringen einer Kraft eine zweite Gate-Elektrode aufweist und der zweite Schaltkreis, dessen Impedanz durch die Biegung der Nanoröhre beeinflusst wird, eine zweite Drain-Elektrode aufweist, die auf dem dritten Niveau der Struktur positioniert ist.

9. Nanoröhreneinrichtung (100) nach Anspruch 1, bei der die Einrichtung vier Gate-Elektroden (g) und zwei Drain-Elektroden (d) aufweist, wobei die Gate-Elektroden (g) mit zwei auf jeder Seite der Nanoröhre (120) auf eine quadratische oder rechteckförmige Weise in Paaren angeordnet sind und die Drain-Elektroden (d) eine auf jeder Seite der Nanoröhre gegenüberliegend voneinander angeordnet sind.

10. Nanoröhreneinrichtung (100) nach Anspruch 1, wobei die Einrichtung zwei Gate-Elektroden (g) und zwei Drain-Elektroden (d) aufweist, wobei die Drain-Elektroden (d) jeweils eine auf jeder Seite der Nanoröhre (120) und unterhalb und näher an der Vorderseite der Röhre als die Gate-Elektroden (g) angeordnet sind, und wobei die Drain-Elektroden (d) jenseits der Nanoröhre (120), eine auf jeder Seite der imaginären Erstreckung der Röhre (120) angeordnet sind.

11. Nanoröhreneinrichtung (100) nach Anspruch 1, wobei die Einrichtung zwei Gate-Elektroden (g) und zwei Drain-Elektroden (d) aufweist, wobei die Gate-Elektroden asymmetrisch bezüglich der Nanoröhre (120) angeordnet sind.

12. Speicherelement, **dadurch gekennzeichnet, dass** dieses die Einrichtung des Anspruchs 1 aufweist.

13. Filter, **dadurch gekennzeichnet, dass** dieser die Einrichtung des Anspruchs 1 aufweist, wobei die Einrichtung Mittel zum Einbringen eines AC-Eingabesignals zum Gate der Einrichtung und Mittel zum Auslesen des Ausgabesignals an dem Drain aufweist.

14. Filter nach Anspruch 13, wobei der Filter Mittel zum Anlegen einer Gate-Vorspannung zum Einstellen einer Resonanzfrequenz des Filters aufweist.

15. Detektor der variablen Bandbreite, **dadurch gekennzeichnet, dass** dieser die Einrichtung des Anspruchs 1 aufweist, wobei das Gate der Einrichtung mit einem Gate-Spannungsmodulator (1310) verbunden ist.

16. Oszillator, **dadurch gekennzeichnet, dass** dieser die Einrichtung des Anspruchs 1 aufweist.

17. Oszillator nach Anspruch 16, wobei ein Rückkopplungsschaltkreis (1420) zwischen dem Drain und einem Gate-Spannungsmodulator (1410) verbunden ist.

18. Variabler Kondensator, **dadurch gekennzeichnet, dass** dieser die Einrichtung des Anspruchs 1 aufweist.

19. Kondensator nach Anspruch 18, bei dem eine induktive Komponente (1520) zwischen dem Source und dem Drain verbunden ist.

20. Einrichtung nach einem der vorhergehenden Ansprüche, bei der die Röhre (120) aus Kohlenstoff, Siliziumkarbid oder Metall gefertigt ist und/oder ein Nanodraht oder ein Nanofaden ist.

21. Nanoröhreneinrichtung nach Anspruch 1, wobei die Einrichtung mit einer Aussparung (1610) in dem Substrat unter der Nanoröhre (120) vorgesehen ist, die einen größeren Bewegungsspielraum der Nanoröhre (120) ermöglicht.

## Revendications

1. Dispositif à nanotube (100), comprenant un nanotube (120) avec une extrémité de base et une extrémité de pointe et avec une extension longitudinale et latérale, une structure de support (130) pour supporter au moins une première partie du nanotube (120) comprenant l'extrémité de base, et des premiers moyens comprenant deux électrodes de grille (140, g) pour exercer une force capacitive sur le nanotube dans une première direction définie par son extension latérale, dans lequel au moins une deuxième partie du nanotube (120) comprenant l'extrémité de pointe fait saillie au-delà du support de ladite structure (130), de telle sorte que, lorsque ladite force dépasse un certain niveau, la deuxième partie du nanotube s'infléchisse, de façon à réduire ainsi une distance tube-drain entre le tube (120) et une électrode de drain (150), **caractérisé en ce qu'**une électrode de source (110) est disposée, ayant une distance ($\Delta z_s > 0$) par rapport à l'extrémité de base du nanotube (120), de telle sorte qu'un effet tunnel puisse être amené à se produire entre le nanotube (120) et ladite électrode de source (110), et dans lequel ledit dispositif comprend de plus deux électrodes de drain (150, d), et dans lequel les électrodes de grille sont disposées à raison d'une sur chaque côté du nanotube (120), et en dessous, et dans lequel les électrodes de drain (150, d) sont disposées à raison d'une sur chaque côté, et en dessous, par rapport au nanotube (120), et plus près de la pointe du tube que l'électrode de grille.

2. Dispositif à nanotube selon la revendication 1, **caractérisé en ce que** les dimensions dudit nanotube (120) et une taille d'une distance verticale (h) entre le tube (120) et la structure de support (130), et une taille d'une distance horizontale ($\Delta z > 0$) entre un tube (160) et l'électrode de drain sont telles qu'un effet tunnel peut être amené à se produire entre le tube (120) et ladite électrode de drain (150).

3. Dispositif à nanotube selon les revendications 1 ou 2, dans lequel ladite structure de support comprend une structure en terrasse avec des structures sur un premier et un deuxième niveaux, la première partie supportée du nanotube étant supportée par le premier niveau de la structure, et lesdits moyens pour exercer une force étant disposés sur ledit deuxième niveau.

4. Dispositif à nanotube selon l'une quelconque des revendications 1 à 3, dans lequel un premier circuit dont l'impédance est affectée par la flexion du nanotube comprend une première électrode de grille qui est disposée sur ledit deuxième niveau de la structure et une première électrode de source qui est disposée sur ledit premier niveau de la structure.

5. Dispositif à nanotube selon l'une quelconque des revendications précédentes, dans lequel la structure de support en terrasse comprend de plus une structure sur un troisième niveau, ledit troisième niveau étant disposé essentiellement en parallèle avec ledit deuxième niveau, mais sur un côté opposé de la partie saillante du nanotube, ce dispositif à nanotube comprenant des deuxièmes moyens pour exercer une force sur le nanotube dans une deuxième direction définie par son extension latérale, de telle sorte que, lorsque ladite force dépasse un certain niveau, la deuxième partie du nanotube s'infléchisse dans la deuxième direction de son extension latérale, de façon à affecter ainsi l'impédance d'un deuxième circuit électrique.

6. Dispositif à nanotube selon la revendication 5, **caractérisé en ce que** les deuxièmes moyens pour exercer ladite force sur le nanotube sont des moyens électriques, la force étant créée par l'application d'une tension aux moyens.

7. Dispositif à nanotube selon les revendications 5 ou 6, dans lequel ladite structure de support additionnelle comprend une structure en terrasse avec des structures sur un premier et un deuxième niveaux, la première partie supportée du nanotube étant supportée par le premier niveau de la structure, et lesdits moyens pour exercer une force étant disposés sur ledit deuxième niveau.

8. Dispositif à nanotube selon l'une quelconque des revendications 5 à 7, dans lequel les deuxièmes moyens pour appliquer une force comprennent une deuxième électrode de grille, et le deuxième circuit dont l'impédance est affectée par la flexion du nanotube comprend une deuxième électrode de drain qui est disposée sur ledit troisième niveau de la structure.

9. Dispositif à nanotube (100) selon la revendication 1, dans lequel ledit dispositif comprend quatre électrodes de grille (g) et deux électrodes de drain (d), les électrodes de grille (g) étant disposées à raison de deux sur chaque côté du nanotube (120) d'une façon quadratique ou rectangulaire par paires, et les électrodes de drain (d) étant disposées à raison d'une sur chaque côté du nanotube, opposées l'une à l'autre.

10. Dispositif à nanotube (100) selon la revendication 1, dans lequel ledit dispositif comprend deux électrodes de grille (g) et deux électrodes de drain (d), les électrodes de drain (d) étant disposées à raison d'une sur chaque côté du nanotube (120) et en dessous de la pointe du tube, et plus près de celle-ci que les électrodes de grille (g), et les électrodes de drain (d) étant disposées au-delà du nanotube (120), à raison d'une sur chaque côté de l'extension imaginaire dudit tube (120).

**11.** Dispositif à nanotube (100) selon la revendication 1, dans lequel ledit dispositif comprend deux électrodes de grille (g) et deux électrodes de drain (d), les électrodes de grille étant disposées de façon asymétrique par rapport au nanotube (120).

**12.** Elément de mémoire, **caractérisé en ce qu'**il comprend le dispositif selon la revendication 1.

**13.** Filtre, **caractérisé en ce qu'**il comprend le dispositif selon la revendication 1, ledit dispositif comprenant des moyens pour appliquer un signal alternatif d'entrée à la grille du dispositif, et des moyens pour lire le signal de sortie au niveau du drain.

**14.** Filtre selon la revendication 13, dans lequel ledit filtre comprend des moyens pour appliquer une polarisation de tension de grille pour accorder une fréquence de résonance dudit filtre.

**15.** Détecteur à largeur de bande variable, **caractérisé en ce qu'**il comprend le dispositif selon la revendication 1, la grille du dispositif étant connectée à un modulateur de tension de grille (1310).

**16.** Oscillateur, **caractérisé en ce qu'**il comprend le dispositif selon la revendication 1.

**17.** Oscillateur selon la revendication 16, dans lequel un circuit de rétroaction (1420) est connecté entre le drain et un modulateur de tension de grille (1410).

**18.** Condensateur variable, **caractérisé en ce qu'**il comprend le dispositif selon la revendication 1.

**19.** Condensateur selon la revendication 18, dans lequel un composant inductif (1520) est connecté entre la source et le drain.

**20.** Dispositif selon l'une quelconque des revendications précédentes, dans lequel ledit tube (120) est réalisé en carbone, en carbure de silicium ou en métal, et/ou est un nanotube ou une nanobarbe.

**21.** Dispositif à nanotube selon la revendication 1, dans lequel ledit dispositif est muni d'une cavité (1610) dans le substrat sous le nanotube (120), permettant un plus grand mouvement dudit nanotube (120).

FIG. 1

FIG. 2

Fig. 3a
Fig. 3b
Fig. 3c
Fig. 3d
Fig. 3e
Fig. 3f

FIG. 3

FIG 4A

FIG 4B

FIG 5A

FIG 5B

FIG.5 c

FIG. 6

FIG. 7

FIG. 8A

FIG. 8B

FIG. 9

FIG. 10A

FIG. 10B

$V_s$

x

1100

$V_g$          $V_d$

FIG. 11

FIG. 12

FIG. 13

FIG. 14

$V_s$ ●

1520

1100

L

$V_{g0}$

1510

$V_d$ ●

FIG. 15

110

120

1620

1520

150

140

1650

1630

$h_c$

1640

130

1610

$L_c$

FIG. 16

## REFERENCES CITED IN THE DESCRIPTION

**Patent documents cited in the description**

- WO 03078305 A
- DE 10034315 A1
- WO 0161753 A1